# EUROPEAN PATENT APPLICATION

(11) **EP 4 575 907 A1**
(43) Date of publication of application: **25.06.2025**
(21) Application number: 23383321.9
(22) Date of filing: 19.12.2023
(51) Int. Cl.: G06N 3/08

(54) **SYSTEM AND METHOD FOR IMPLEMENTING TENSOR NETWORK RESERVOIR COMPUTING FOR MACHINE LEARNING AND RELATED METHODS**

(71) Applicant: Multiverse Computing S.L., 20009 Donostia (ES)
(72) Inventor: ORUS, Roman, 20009 Donostia (Gipuzkoa) (ES)
(74) Representative: Balder IP Law, S.L.

(57) **Abstract**

A computational system and method are disclosed. The system and method involve receiving sequential data, a computational mapping, and a network-based computing for each computational network. An initial computational mapping of a complex system is determined using a computational network. A computational network adaptation and an intensity of the adaptation are identified based on the network-based computing, the computational mapping, and a prediction task. Modified mathematical series in the computational network are rendered by applying the computational network adaptation. An updated computational mapping is determined and, if the updated computational mapping indicates that the prediction task has decreased, a priority weight for the computational network adaptation is increased. The computational network adaptation, the intensity of the adaptation, and the priority weight are saved in a user profile for the complex system.

## Description

### TECHNICAL FIELD

The invention is a system and method for machine learning, specifically using tensor network reservoir computing for time prediction.

### BACKGROUND

Machine learning is a field of artificial intelligence that uses statistical techniques to give computer systems the ability to learn from data, without being explicitly programmed. One of the challenges in machine learning is the efficient processing of large datasets. Traditional machine learning methods often struggle with handling large datasets due to computational limitations. Reservoir computing is a framework for training recurrent neural networks, and it has been used to address this challenge. However, there are still limitations in terms of scalability and efficiency. Furthermore, time prediction is a crucial task in many applications, but it is often difficult to achieve accurate results due to the complexity of the data and the limitations of existing methods. Volterra series is a mathematical tool that has been used for time prediction, but it also has its own limitations, such as the difficulty in expanding the series and optimizing the outcome.

### SUMMARY

In accordance with embodiments, a computational system and method are provided for prediction tasks in complex systems. Sequential data, a computational mapping, and network-based computing are received for each computational network. An initial computational mapping of a complex system is determined using a computational network to view mathematical series based on the network-based computing. A computational network adaptation and an intensity of the adaptation are identified, where the adaptation is any one of an object velocity back and forth adaptation, a rotation movement calibration adaptation, and an object position adaptation. Modified mathematical series are rendered in the computational network by applying the adaptation based on its intensity. An updated computational mapping is determined. In response to determining that the updated computational mapping indicates that the prediction task has decreased, a priority weight for the computational network adaptation is increased. The computational network adaptation, the intensity of the adaptation, and the priority weight are saved in a user profile for the complex system.

### BRIEF DESCRIPTION OF THE DRAWINGS

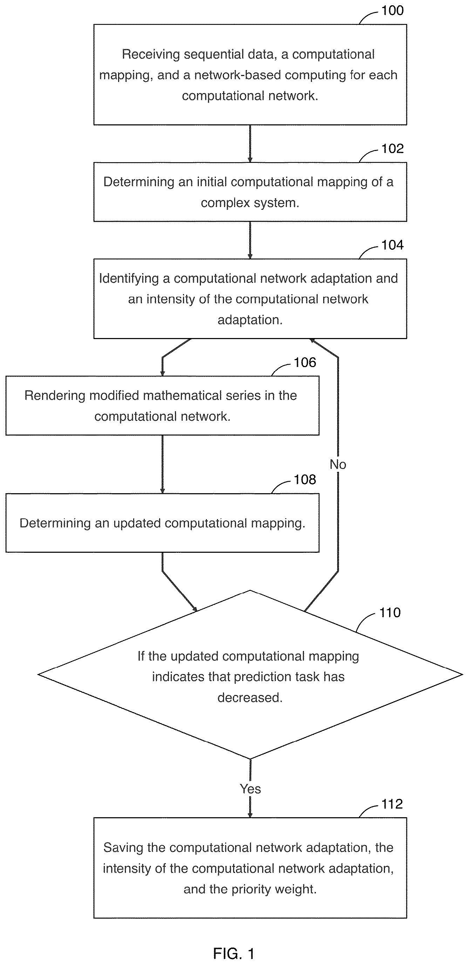

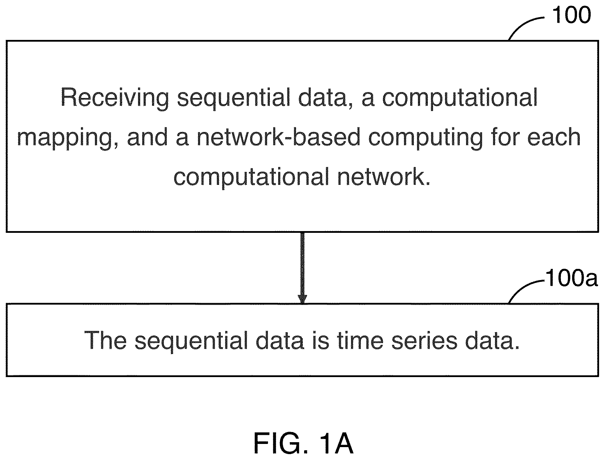

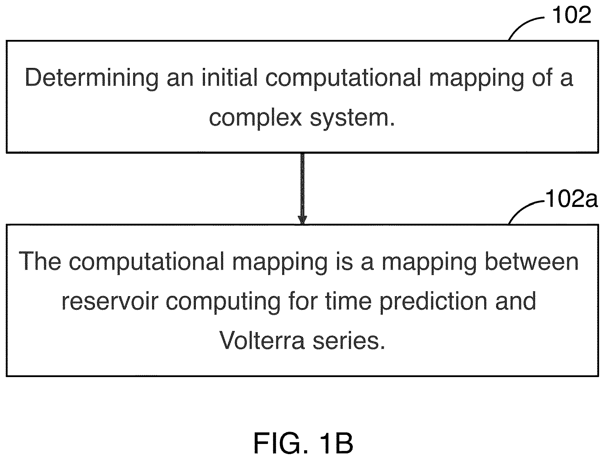

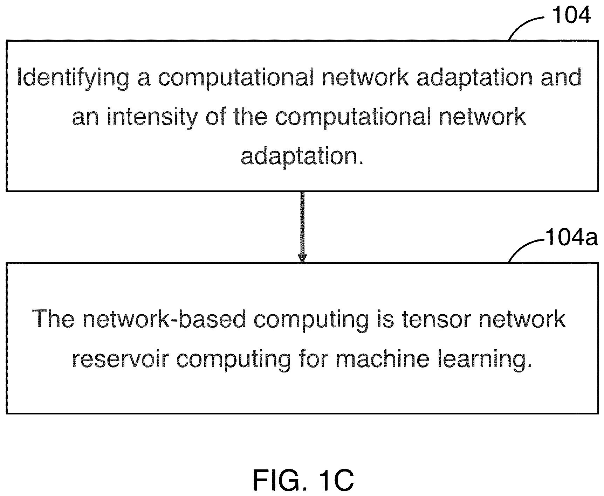

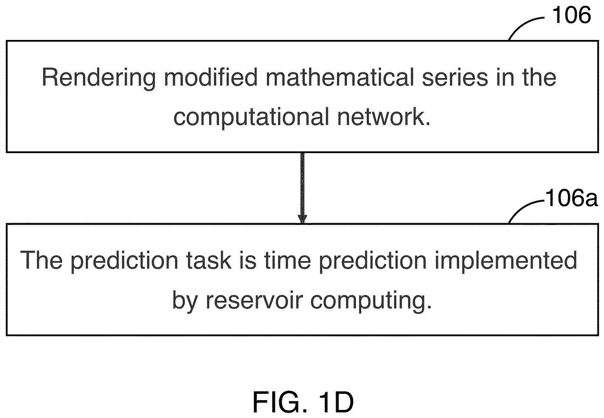

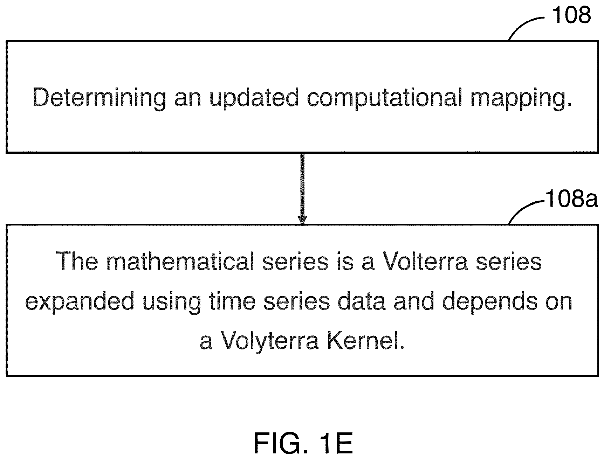

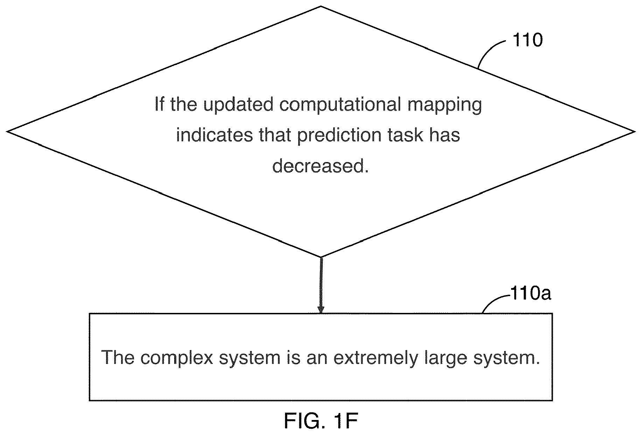

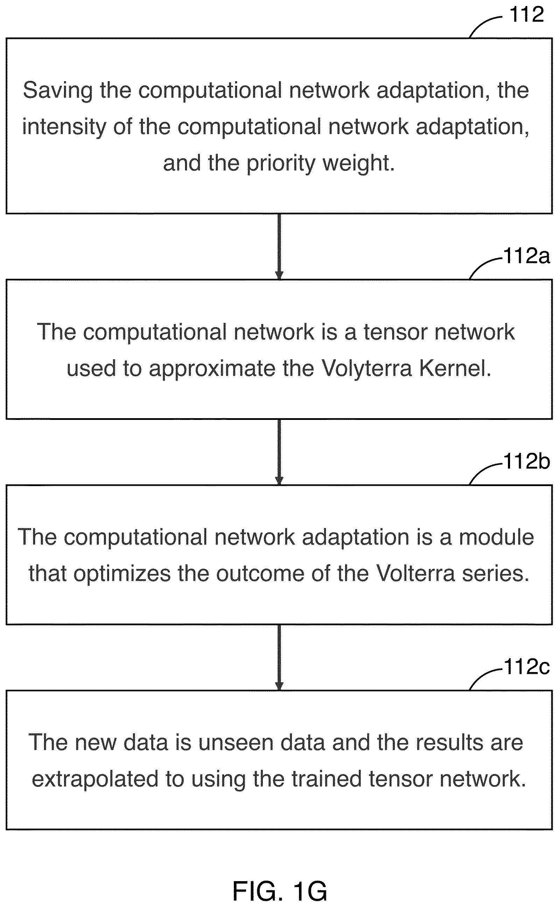

FIG. 1 illustrates, in a flowchart, operations for optimizing a computational network using tensor network reservoir computing in accordance with certain embodiments.
FIG. 1A illustrates, in a flowchart, operations for receiving sequential data for computational mapping in accordance with certain embodiments.
FIG. 1B illustrates, in a flowchart, operations for determining an initial computational mapping using a specific mapping in accordance with certain embodiments.
FIG. 1C illustrates, in a flowchart, operations for identifying a computational network adaptation and its intensity in accordance with certain embodiments.
FIG. 1D illustrates, in a flowchart, operations for rendering modified mathematical series in the computational network in accordance with certain embodiments.
FIG. 1E illustrates, in a flowchart, operations for determining an updated computational mapping using a specific mathematical series in accordance with certain embodiments.
FIG. 1F illustrates, in a flowchart, operations for deciding whether to increase the priority weight for the computational network adaptation based on the updated computational mapping in accordance with certain embodiments.
FIG. 1G illustrates, in a flowchart, operations for saving the computational network adaptation, its intensity, and the priority weight using a specific computational network in accordance with certain embodiments.

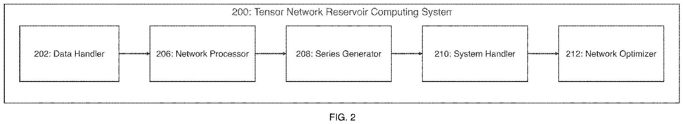

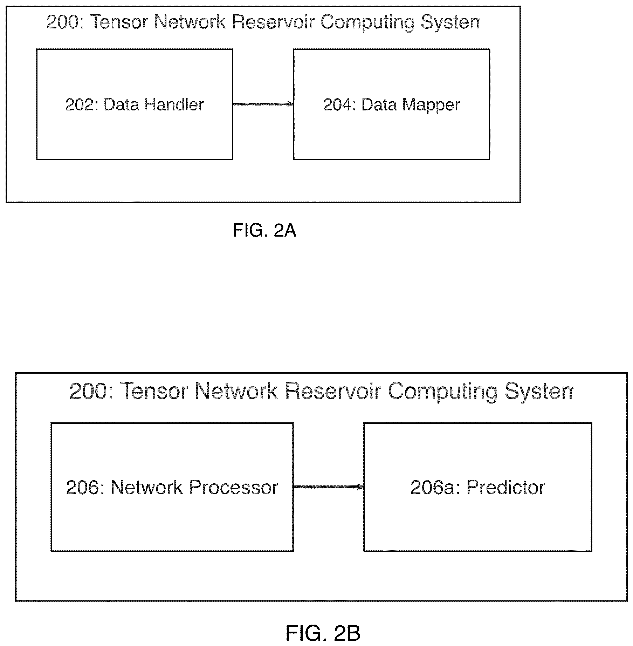

FIG. 2 illustrates, in a block diagram, the components of the Tensor Network Reservoir Computing System in accordance with certain embodiments.
FIG. 2A illustrates, in a block diagram, the interaction between the Data Handler and Data Mapper components in the Tensor Network Reservoir Computing System.
FIG. 2B illustrates, in a block diagram, the hierarchy and interaction between the Network Processor and its sub-component, the Predictor, in the Tensor Network Reservoir Computing System.

### DETAILED DESCRIPTION

Step 100 and its sub-step 100-a from Step 6 involve the action of receiving sequential data, a computational mapping, and a network-based computing for each computational network, wherein the network-based computing comprises a prediction task. This step represents the initial phase of the computational method where the system is set up with the necessary inputs for processing.

The components involved in this step are the computational system, sequential data, computational mapping, and network-based computing. The computational system, which could be a computer or a network of computers, performs the action of receiving the sequential data. This data could be any form of time-ordered data, such as stock prices, weather data, or sensor readings. In the context of Claim 12, the sequential data is specifically time series data.

The computational mapping is a mathematical or algorithmic method that translates the sequential data into a format that can be processed by the network-based computing. In the context of Claim 13, the computational mapping is a mapping between reservoir computing for time prediction and Volterra series.

The network-based computing is a computational model that processes the mapped data to perform a prediction task. This could be any form of machine learning or artificial intelligence model that is capable of making predictions based on input data. In the context of Claim 14, the network-based computing is tensor network reservoir computing for machine learning.

The components perform these actions to set up the computational system with the necessary inputs for processing. This is done to enable the system to make accurate predictions based on the input data. The accuracy of these predictions can have significant implications in various fields, such as finance, weather forecasting, and healthcare.

Step 102 and its sub-step 102-a from Step 6 involve the action of determining an initial computational mapping of a system using a computational network to view mathematical series in a computational network based on the network-based computing. This step represents the phase where the computational system begins processing the input data.

The components involved in this step are the computational system, computational mapping, system, computational network, and mathematical series. The computational system, which could be a computer or a network of computers, performs the action of determining the computational mapping. This mapping is a mathematical or algorithmic method that translates the sequential data into a format that can be processed by the network-based computing. In the context of Claim 13, the computational mapping is a mapping between reservoir computing for time prediction and Volterra series.

The system refers to the large-scale system that the computational system is trying to model or predict. In the context of Claim 17, the system is a large system. The computational network is a model that processes the mapped data to perform a prediction task. This could be any form of machine learning or artificial intelligence model that is capable of making predictions based on input data. In the context of Claim 18, the computational network is a tensor network used to approximate the Volyterra Kernel and used in the optimization of the Volterra series outcome.

The mathematical series is a sequence of numbers or symbols that represents the sequential data in a format that can be processed by the computational network. In the context of Claim 16, the mathematical series is a Volterra series expanded using time series data and depends on a Volyterra Kernel.

The components perform these actions to enable the computational system to process the input data and make predictions. This is done to model or predict the behavior of the system based on the input data. The accuracy of these predictions can have implications in various fields, such as finance, weather forecasting, and healthcare.

Step 104 from Step 6 involves the action of identifying a computational network adaptation and an intensity of the computational network adaptation based on the network-based computing, the computational mapping, and the prediction task for each computational network. This step represents the phase where the computational system adjusts its processing based on the input data and the initial computational mapping.

The components involved in this step are the computational system, computational network adaptation, network-based computing, computational mapping, and prediction task. The computational system, which could be a computer or a network of computers, performs the action of identifying the computational network adaptation. This adaptation is a modification or adjustment to the computational network that enhances its ability to process the input data and perform the prediction task. In the context of Claim 19, the computational network adaptation is a module that optimizes the outcome of the Volterra series by minimizing a cost function over a training dataset, with the minimization being carried variationally over the tensors of the tensor network of the Volterra series.

The network-based computing, computational mapping, and prediction task are the factors that influence the identification of the computational network adaptation. The network-based computing is a computational model that processes the mapped data to perform a prediction task. The computational mapping is a mathematical or algorithmic method that translates the sequential data into a format that can be processed by the network-based computing. The prediction task is the goal or objective that the computational system is trying to achieve.

The components perform these actions to enable the computational system to adjust its processing based on the input data and the initial computational mapping. This is done to enhance the system's ability to make predictions based on the input data. The accuracy of these predictions can have implications in various fields, such as finance, weather forecasting, and healthcare.

Step 106 from Step 6 involves the action of rendering modified mathematical series in the computational network by applying the computational network adaptation based on the intensity of the computational network adaptation. This step represents the phase where the computational system applies the identified adaptations to the computational network to enhance its processing of the input data.

The components involved in this step are the computational system, mathematical series, computational network, and computational network adaptation. The computational system, which could be a computer or a network of computers, performs the action of rendering the mathematical series. This series is a sequence of numbers or symbols that represents the sequential data in a format that can be processed by the computational network. In the context of Claim 16, the mathematical series is a Volterra series expanded using time series data and depends on a Volyterra Kernel.

The computational network is a model that processes the mapped data to perform a prediction task. This could be any form of machine learning or artificial intelligence model that is capable of making predictions based on input data. In the context of Claim 18, the computational network is a tensor network used to approximate the Volyterra Kernel and used in the optimization of the Volterra series outcome.

The computational network adaptation is a modification or adjustment to the computational network that enhances its ability to process the input data and perform the prediction task. The computational system applies this adaptation to the computational network based on the intensity of the computational network adaptation. In the context of Claim 19, the computational network adaptation is a module that optimizes the outcome of the Volterra series by minimizing a cost function over a training dataset, with the minimization being carried variationally over the tensors of the tensor network of the Volterra series.

The components perform these actions to enable the computational system to enhance its processing of the input data and improve the accuracy of its predictions. This is done to model or predict the behavior of the system based on the input data. The accuracy of these predictions can have implications in various fields, such as finance, weather forecasting, and healthcare.

Step 108 from Step 6 involves the action of determining an updated computational mapping. This step represents the phase where the computational system updates the computational mapping based on the modified mathematical series and the applied computational network adaptation.

The components involved in this step are the computational system, computational mapping, mathematical series, and computational network adaptation. The computational system, which could be a computer or a network of computers, performs the action of determining the updated computational mapping. This mapping is a mathematical or algorithmic method that translates the modified mathematical series into a format that can be processed by the computational network. In the context of Claim 13, the computational mapping is a mapping between reservoir computing for time prediction and Volterra series.

The mathematical series is a sequence of numbers or symbols that represents the sequential data in a format that can be processed by the computational network. In the context of Claim 16, the mathematical series is a Volterra series expanded using time series data and depends on a Volyterra Kernel.

The computational network adaptation is a modification or adjustment to the computational network that enhances its ability to process the input data and perform the prediction task. The computational system applies this adaptation to the computational network based on the intensity of the computational network adaptation. In the context of Claim 19, the computational network adaptation is a module that optimizes the outcome of the Volterra series by minimizing a cost function over a training dataset, with the minimization being carried variationally over the tensors of the tensor network of the Volterra series.

The components perform these actions to enable the computational system to update its computational mapping based on the modified mathematical series and the applied computational network adaptation. This is done to enhance the system's ability to make predictions based on the input data. The accuracy of these predictions can have implications in various fields, such as finance, weather forecasting, and healthcare.

Step 110 from Step 6 involves the action of increasing a priority weight for the computational network adaptation in response to determining that the updated computational mapping indicates that the prediction task has decreased. This step represents the phase where the computational system adjusts the importance of the computational network adaptation based on the performance of the prediction task.

The components involved in this step are the computational system, computational network adaptation, computational mapping, and prediction task. The computational system, which could be a computer or a network of computers, performs the action of increasing the priority weight for the computational network adaptation. This priority weight is a measure of the importance or influence of the computational network adaptation in the computational system's processing of the input data and performance of the prediction task.

The computational network adaptation is a modification or adjustment to the computational network that enhances its ability to process the input data and perform the prediction task. The computational system applies this adaptation to the computational network based on the intensity of the computational network adaptation. In the context of Claim 19, the computational network adaptation is a module that optimizes the outcome of the Volterra series by minimizing a cost function over a training dataset, with the minimization being carried variationally over the tensors of the tensor network of the Volterra series.

The computational mapping is a mathematical or algorithmic method that translates the modified mathematical series into a format that can be processed by the computational network. The prediction task is the goal or objective that the computational system is trying to achieve.

The components perform these actions to enable the computational system to adjust the importance of the computational network adaptation based on the performance of the prediction task. This is done to enhance the system's ability to make predictions based on the input data. The accuracy of these predictions can have implications in various fields, such as finance, weather forecasting, and healthcare.

Step 112 and its sub-steps 112-a, 112-b, and 112-c from Step 6 involve the action of saving the computational network adaptation, the intensity of the computational network adaptation, and the priority weight in a user profile for the system. This step represents the phase where the computational system stores the results of its processing for future use.

The components involved in this step are the computational system, computational network adaptation, intensity of the computational network adaptation, priority weight, and user profile. The computational system, which could be a computer or a network of computers, performs the action of saving the computational network adaptation, its intensity, and the priority weight. These are the results of the computational system's processing of the input data and performance of the prediction task, and they are stored for future use in a user profile for the system.

The computational network adaptation is a modification or adjustment to the computational network that enhances its ability to process the input data and perform the prediction task. The intensity of the computational network adaptation is a measure of the extent or degree of the adaptation. The priority weight is a measure of the importance or influence of the computational network adaptation in the computational system's processing of the input data and performance of the prediction task. In the context of Claim 19, the computational network adaptation is a module that optimizes the outcome of the Volterra series by minimizing a cost function over a training dataset, with the minimization being carried variationally over the tensors of the tensor network of the Volterra series.

The user profile is a record or account that stores the results of the computational system's processing for future use. This could be a file, a database entry, or any other form of data storage. The system is the large-scale system that the computational system is trying to model or predict. In the context of Claim 17, the system is a large system.

The components perform these actions to enable the computational system to store the results of its processing for future use. This is done to allow the system to reference these results in future computations, which can enhance the system's ability to make predictions based on the input data. The accuracy of these predictions can have implications in various fields, such as finance, weather forecasting, and healthcare.

The Tensor Network Reservoir Computing System, numbered as 200, is designed to handle complex computations and predictions, making it a tool in the field of machine learning and artificial intelligence.

The system is composed of several components, each playing a role in its operation. The Data Handler, numbered as 202, manages sequential data, which can be time series data or unseen data.

The Data Mapper, numbered as 204, determines the computational mapping, which is a process that establishes the relationship between two sets of data. In this case, it creates a mapping between reservoir computing for time prediction and Volterra series.

The Network Processor, numbered as 206, handles network-based computing. It uses tensor network reservoir computing for machine learning, and it also approximates the Volyterra Kernel and optimizes the outcome of the Volterra series.

The Predictor, a sub-component of the Network Processor and numbered as 206-a, implements time prediction through reservoir computing.

The Series Generator, numbered as 208, handles the mathematical series, specifically the Volterra series expanded using time series data and depending on a Volyterra Kernel.

The System Handler, numbered as 210, manages the complex system, which can be an extremely large system.

Finally, the Network Optimizer, numbered as 212, identifies and applies computational network adaptations. It optimizes the outcome of the Volterra series by minimizing a cost function over a training dataset.

The system begins its operation with the Data Handler managing the flow of sequential data. The Data Mapper then determines the computational mapping. The Network Processor then handles the network-based computing and approximates the Volyterra Kernel and optimizes the outcome of the Volterra series. The Predictor sub-component implements time prediction through reservoir computing. The Series Generator handles the mathematical series. The System Handler manages the complex system. Finally, the Network Optimizer identifies and applies computational network adaptations and optimizes the outcome of the Volterra series.

The Data Handler, numbered as 202, is a part of the Tensor Network Reservoir Computing System. This component manages the flow of sequential data, which can be time series data or unseen data.

The Data Handler is composed of several entities. Sequential data is managed by this component. This data is arranged in a specific order, facilitating the subsequent computational processes.

The Data Mapper, a sub-component of the Data Handler and numbered as 204, determines the computational mapping. This process establishes the relationship between two sets of data. In this case, it creates a mapping between reservoir computing for time prediction and Volterra series.

The Data Handler begins its operation by managing the flow of sequential data. The Data Mapper then determines the computational mapping. These components ensure the smooth and efficient operation of the system. Their functions are integral to the system's ability to handle complex computations and make accurate predictions.

The Data Mapper, numbered as 204, is a part of the Tensor Network Reservoir Computing System. This component determines the computational mapping, a process that establishes the relationship between two sets of data. In this context, it creates a mapping between reservoir computing for time prediction and Volterra series.

The Data Mapper operates by determining the computational mapping. This process establishes the relationship between two sets of data. The mapping provides a framework for how the data will be processed and analyzed. The Data Mapper operates under the condition that the data is arranged in a specific order, which is managed by the Data Handler.

The method involves creating a mapping between reservoir computing for time prediction and Volterra series. This mapping is then used to process and analyze the data. The Data Mapper's function is integral to the operation of the system, providing the necessary groundwork for the system's predictive capabilities. Its operation is a fundamental aspect of the system's function, ensuring the smooth and efficient operation of the system.

The Network Processor, numbered as 206, is a part of the Tensor Network Reservoir Computing System. This component handles network-based computing. It uses tensor network reservoir computing for machine learning, and it also approximates the Volyterra Kernel and optimizes the outcome of the Volterra series.

The Network Processor operates by handling network-based computing. This process allows the system to learn and adapt over time. The Network Processor uses tensor network reservoir computing for machine learning, and it also approximates the Volyterra Kernel and optimizes the outcome of the Volterra series.

The Predictor, a sub-component of the Network Processor and numbered as 206-a, operates by implementing time prediction through reservoir computing. This process involves using the established computational mapping and the processed data to make predictions about future data points.

Together, the Network Processor and the Predictor ensure the smooth and efficient operation of the system. Their functions allow the system to handle complex computations and make accurate predictions.

The Series Generator, numbered as 208, is a part of the Tensor Network Reservoir Computing System. This component handles the mathematical series, specifically the Volterra series expanded using time series data and depending on a Volyterra Kernel.

The Series Generator operates by handling the mathematical series. This process involves managing the Volterra series, which is expanded using time series data and depends on a Volyterra Kernel. The handling of the mathematical series is a function of the Series Generator.

The method involves expanding the Volterra series using time series data and depending on a Volyterra Kernel. This series is then used to process and analyze the data.

The Series Generator's function is integral to the operation of the system. Its operation ensures the smooth and efficient operation of the system.

The System Handler, numbered as 210, is a part of the Tensor Network Reservoir Computing System. This component manages the complex system, which can be an extremely large system.

The System Handler operates by managing the complex system. This process involves handling an extremely large system. The management of the complex system is a function of the System Handler.

The method involves managing the complex system, which can be an extremely large system. This system is then used to process and analyze the data.

The System Handler's function is integral to the operation of the system. Its operation ensures the smooth and efficient operation of the system.

The Network Optimizer, numbered as 212, is a part of the Tensor Network Reservoir Computing System. This component identifies and applies computational network adaptations. It optimizes the outcome of the Volterra series by minimizing a cost function over a training dataset. This optimization process is carried out variationally over the tensors of the tensor network of the Volterra series.

The Network Optimizer operates by identifying and applying computational network adaptations. This process adjusts the computational network to improve its performance. The Network Optimizer optimizes the outcome of the Volterra series by minimizing a cost function over a training dataset.

The method involves minimizing a cost function over a training dataset, which is carried out variationally over the tensors of the tensor network of the Volterra series. This process contributes to the system's ability to make accurate predictions.

The Network Optimizer's function is integral to the operation of the system. Its operation ensures the smooth and efficient operation of the system.

## Claims

1. A computational system, comprising:
receiving sequential data, a computational mapping, and a network-based computing for each computational network, wherein the network-based computing comprises a prediction task;
determining an initial computational mapping of a complex system using a computational network to view mathematical series in a computational network based on the network-based computing;
identifying a computational network adaptation and an intensity of the computational network adaptation based on the network-based computing, the computational mapping, and the prediction task for each computational network, wherein the computational network adaptation is any one or more of an object velocity back and forth adaptation, a rotation movement calibration adaptation, and an object position adaptation;
rendering modified mathematical series in the computational network by applying the computational network adaptation based on the intensity of the computational network adaptation;
determining an updated computational mapping;
in response to determining that the updated computational mapping indicates that prediction task has decreased,
increasing a priority weight for the computational network adaptation; and
saving the computational network adaptation, the intensity of the computational network adaptation, and the priority weight in a user profile for the complex system.

2. The computational system of claim 1, wherein the sequential data is time series data.

3. The computational system of claim 2, wherein the computational mapping is a mapping between reservoir computing for time prediction and Volterra series.

4. The computational system of claim 3, wherein the network-based computing is tensor network reservoir computing for machine learning.

5. The computational system of claim 4, wherein the prediction task is time prediction implemented by reservoir computing.

6. The computational system of claim 5, wherein the mathematical series is a Volterra series expanded using time series data and depends on a Volyterra Kernel.

7. The computational system of claim 6, wherein the complex system is an extremely large system.

8. The computational system of claim 7, wherein the computational network is a tensor network used to approximate the Volyterra Kernel and used in the optimization of the Volterra series outcome.

9. The computational system of claim 8, wherein the computational network adaptation is a module that optimizes the outcome of the Volterra series by minimizing a cost function over a training dataset, with the minimization being carried variationally over the tensors of the tensor network of the Volterra series.

10. The computational system of claim 9, wherein the new data is unseen data and the results are extrapolated to using the trained tensor network.

11. A computational method, comprising:
receiving sequential data, a computational mapping, and a network-based computing for each computational network, wherein the network-based computing comprises a prediction task;
determining an initial computational mapping of a complex system using a computational network to view mathematical series in a computational network based on the network-based computing;
identifying a computational network adaptation and an intensity of the computational network adaptation based on the network-based computing, the computational mapping, and the prediction task for each computational network, wherein the computational network adaptation is any one or more of an object velocity back and forth adaptation, a rotation movement calibration adaptation, and an object position adaptation;
rendering modified mathematical series in the computational network by applying the computational network adaptation based on the intensity of the computational network adaptation;
determining an updated computational mapping;
in response to determining that the updated computational mapping indicates that prediction task has decreased,
increasing a priority weight for the computational network adaptation; and
saving the computational network adaptation, the intensity of the computational network adaptation, and the priority weight in a user profile for the complex system.

12. The computational method of claim 11, wherein the sequential data is time series data.

13. The computational method of claim 12, wherein the computational mapping is a mapping between reservoir computing for time prediction and Volterra series.

14. The computational method of claim 13, wherein the network-based computing is tensor network reservoir computing for machine learning.

15. The computational method of claim 14, wherein the prediction task is time prediction implemented by reservoir computing.

16. The computational method of claim 15, wherein the mathematical series is a Volterra series expanded using time series data and depends on a Volyterra Kernel.

17. The computational method of claim 16, wherein the complex system is an extremely large system.

18. The computational method of claim 17, wherein the computational network is a tensor network used to approximate the Volyterra Kernel and used in the optimization of the Volterra series outcome.

19. The computational method of claim 18, wherein the computational network adaptation is a module that optimizes the outcome of the Volterra series by minimizing a cost function over a training dataset, with the minimization being carried variationally over the tensors of the tensor network of the Volterra series.

20. The computational method of claim 19, wherein the new data is unseen data and the results are extrapolated to using the trained tensor network.
